# EUROPEAN PATENT APPLICATION

(11) **EP 4 514 086 A1**
(43) Date of publication of application: **26.02.2025**
(21) Application number: 24802537.1
(22) Date of filing: 22.01.2024
(51) Int. Cl.: H05K 7/20

(54) **LIQUID COOLING MODULE AND VEHICLE**

(30) Priority: 09.05.2023 CN 202310527393
(71) Applicant: Shenzhen Yinwang Intelligent Technologies Co., Ltd., Shenzhen, Guangdong 518129 (CN)
(72) Inventor: PENG, Yaofeng, Shenzhen, Guangdong 518129 (CN); LI, Zengshan, Shenzhen, Guangdong 518129 (CN)
(74) Representative: Pfenning, Meinig & Partner mbB
(86) International application number: PCT/CN2024/073527
(87) International publication number: WO 2024/230249

(57) **Abstract**

This application provides a liquid cooling module and a vehicle. The liquid cooling module includes a cold plate, a circuit board, and a temperature sensor. The cold plate includes a main body part and a protruding part, and the main body part is fastened to the circuit board. The main body part includes a first surface, the circuit board includes a second surface, the first surface is disposed opposite to the second surface, and the protruding part is disposed on the first surface. The temperature sensor is disposed on the second surface, the temperature sensor is disposed adjacent to the protruding part, and the temperature sensor is connected to the protruding part through a thermally conductive medium. In this way, the temperature sensor may be configured to exchange heat with the protruding part, and the temperature sensor may monitor a temperature of cooling fluid in a flow channel by using the protruding part, so that during assembling of the temperature sensor, no temperature sensor with long pins needs to be connected to the circuit board, and no protective sleeve needs to be disposed on the circuit board. Therefore, complexity of assembling the temperature sensor is reduced, and reliability is improved.

## Description

This application claims priority to Chinese Patent Application 202310527393.0, filed with the China National Intellectual Property Administration on May 9, 2023 and entitled "LIQUID COOLING MODULE AND VEHICLE", which is incorporated herein by reference in its entirety.

### TECHNICAL FIELD

This application relates to the field of vehicle technologies, and in particular, to a liquid cooling module and a vehicle.

### BACKGROUND

A vehicle usually includes a cooling fluid circulation loop, to dissipate heat for a specific device. The cooling fluid circulation loop may be connected to a liquid cooling module.

Usually, the liquid cooling module may include a heat generating assembly, a cold plate, and a temperature sensor. The heat generating assembly generates heat during running. The heat generating assembly may include a circuit board and a component mounted on the circuit board. The cold plate is fastened to the circuit board. The cold plate may be connected to the cooling fluid circulation loop of the vehicle. Heat may be dissipated, by using the cold plate, for the circuit board and the component mounted on the circuit board. The temperature sensor may be configured to monitor a temperature of cooling fluid in the cold plate.

However, a process of deploying the temperature sensor configured to monitor the temperature of the cooling fluid in the cold plate of the liquid cooling module is complex, and is difficult to implement.

### SUMMARY

This application provides a liquid cooling module and a vehicle, to reduce deployment complexity of deploying, in the liquid cooling module, a temperature sensor configured to monitor cooling fluid.

A first aspect of this application provides a liquid cooling module, including a cold plate, a circuit board, and a temperature sensor. The cold plate includes a main body part and a protruding part, and the main body part is fastened to the circuit board. The main body part includes a first surface, the circuit board includes a second surface, the first surface is disposed opposite to the second surface, and the protruding part is disposed on the first surface. The temperature sensor is disposed on the second surface, the temperature sensor is disposed adjacent to the protruding part, and the temperature sensor is connected to the protruding part through a thermally conductive medium.

According to the liquid cooling module in this application, the temperature sensor may be configured to exchange heat with the protruding part, and the temperature sensor may monitor a temperature of cooling fluid in a flow channel by using the protruding part, so that during assembling of the temperature sensor, no temperature sensor with long pins needs to be connected to the circuit board, and no protective sleeve needs to be disposed on the circuit board. Therefore, complexity of assembling the temperature sensor is reduced, and reliability is improved.

In a possible implementation, the main body part has an inlet end, and the protruding part is located at the inlet end. The main body part has a flow channel inside, and the inlet end of the main body part is provided with a cooling fluid inlet for cooling fluid to flow into the flow channel.

In a possible implementation, one end that is of the protruding part and that is away from the main body part is in contact with the second surface. The circuit board includes a thermally conductive part located between the protruding part and the temperature sensor, the thermally conductive medium includes the thermally conductive part, and the protruding part is connected to the temperature sensor through the thermally conductive part.

In a possible implementation, the thermally conductive part includes a thermally conductive sheet, one end of the thermally conductive sheet is close to the protruding part, and the other end of the thermally conductive sheet is close to the temperature sensor.

In a possible implementation, the temperature sensor is disposed in non-contact with the thermally conductive sheet, and the temperature sensor and the thermally conductive sheet are insulated from each other.

In a possible implementation, at least a part of the temperature sensor is disposed on a surface of the thermally conductive sheet.

In a possible implementation, at least a part of the end that is of the protruding part and that is away from the main body part is in contact with the thermally conductive sheet.

In a possible implementation, the end that is of the protruding part and that is away from the main body part is disposed in non-contact with the thermally conductive sheet.

In a possible implementation, the end that is of the protruding part and that is away from the main body part is fastened to the circuit board, so that the main body part is fastened to the circuit board through the protruding part.

In a possible implementation, a threaded hole is provided at the end that is of the protruding part and that is away from the main body part, the circuit board is provided with a mounting hole opposite to the threaded hole, the mounting hole is a through hole, a screw passes through the mounting hole, and the screw is in threaded connection with a hole wall of the threaded hole, so that the circuit board is fastened to the protruding part.

In a possible implementation, the thermally conductive medium includes a thermal interface material. The protruding part is disposed opposite to the temperature sensor, and an end face of one end that is of the protruding part and that is away from the main body part is connected to the temperature sensor through the thermal interface material.

In a possible implementation, the main body part and the protruding part are of an integrated structure.

In a possible implementation, the liquid cooling module further includes a processor. The processor is disposed on the circuit board. The temperature sensor is electrically connected to the processor through a line in the circuit board, to transmit temperature-related data to the processor. The processor is configured to determine a temperature of cooling fluid in the main body part based on the temperature-related data.

In a possible implementation, the processor is specifically configured to: determine a detected temperature at the temperature sensor based on the temperature-related data, and determine the temperature of the cooling fluid in the main body part based on the detected temperature and a temperature difference. The temperature difference is a pre-obtained difference between the temperature at the temperature sensor and the temperature of the cooling fluid in the main body part.

In a possible implementation, the temperature sensor is a surface-mount sensor, and the temperature sensor is attached to the second surface.

A second aspect of this application provides a vehicle, including a heat exchanger and the liquid cooling module in any one of the foregoing implementations. The main body part of the cold plate of the liquid cooling module is connected in series to the heat exchanger, so that a cooling fluid circulation loop is formed between the heat exchanger and the main body part.

### BRIEF DESCRIPTION OF DRAWINGS

FIG. 1 is a diagram of a structure of a cooling fluid circulation loop of a vehicle according to an embodiment of this application;
FIG. 2 is a diagram of a structure of a liquid cooling module according to an embodiment of this application;
FIG. 3 is a diagram of a structure of another liquid cooling module according to an embodiment of this application;
FIG. 4 is a diagram of a structure of still another liquid cooling module according to an embodiment of this application;
FIG. 5 is a diagram of a structure of still another liquid cooling module according to an embodiment of this application; and
FIG. 6 is a diagram of a structure of still another liquid cooling module according to an embodiment of this application.

### Descriptions of reference numerals:

10: first cooling fluid circulation loop;
11: first liquid cooling module; 12: power battery; 13: first pump;
20: second cooling fluid circulation loop;
21: second liquid cooling module; 22: motor; 23: three-way valve; 24: second heat exchanger; 25: second pump;
30: third cooling fluid circulation loop;
31: third heat exchanger; 32: compressor;
40: first heat exchanger;
50: fan;
100: cold plate;
110: main body part;
111: first surface; 112: inlet end; 113: cooling fluid inlet; 114: outlet end; 115: cooling fluid outlet; 116: flow channel;
120: first protruding part;
130: second protruding part;
140: third protruding part;
150: fourth protruding part;
200: circuit board;
210: second surface; 220: line; 230: thermally conductive part; 240: thermally conductive sheet;
310: first screw; 320: second screw; 330: third screw; 340: fourth screw;
400: temperature sensor;
500: processor;
600: second thermal interface material;
700: component;
800: first thermal interface material.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

An embodiment of this application provides a vehicle. The vehicle may include but is not limited to a pure electric vehicle (pure electric vehicle/battery electric vehicle, PEV/BEV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), a subway train, an electric multiple unit, a high-speed train, and the like.

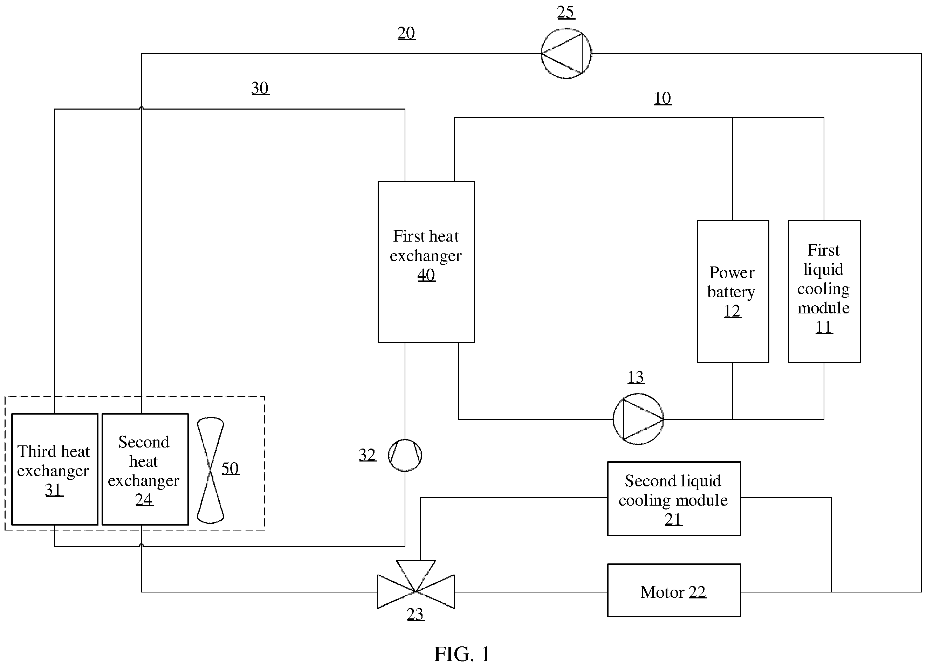

The vehicle provided in this embodiment of this application may include a plurality of cooling fluid circulation loops, for example, a first cooling fluid circulation loop 10, a second cooling fluid circulation loop 20, and a third cooling fluid circulation loop 30 in FIG. 1. The first cooling fluid circulation loop 10 includes a first flow channel (not shown) of a first heat exchanger 40 and a cold plate (not shown) of a power battery 12. After cooling fluid in the first cooling fluid circulation loop 10 absorbs heat generated by the power battery 12 at the power battery 12, heat may be dissipated by using the first heat exchanger 40.

In this embodiment of this application, a first pump 13 is further disposed in the first cooling fluid circulation loop 10. The first pump 13 is connected in series between the first flow channel of the first heat exchanger 40 and the power battery 12. The first pump 13 is configured to drive the cooling fluid in the first cooling fluid circulation loop 10 to flow.

In this embodiment of this application, the vehicle may further include a first liquid cooling module 11. A cold plate (not shown in the figure) of the first liquid cooling module 11 is connected in series to the first flow channel of the first heat exchanger 40, to connect the first liquid cooling module 11 and the first cooling fluid circulation loop 10. After the cooling fluid in the first cooling fluid circulation loop 10 absorbs heat generated by the first liquid cooling module 11 at the first liquid cooling module 11, heat may be dissipated by using the first heat exchanger 40.

In the first cooling fluid circulation loop 10, the cold plate of the first liquid cooling module 11 may be connected in series to the cold plate of the power battery 12, or may be connected in parallel to the cold plate of the power battery 12.

The second cooling fluid circulation loop 20 includes a flow channel (not shown) of a second heat exchanger 24 and a cold plate (not shown) of a motor 22. After cooling fluid in the second cooling fluid circulation loop 20 absorbs heat generated by the motor 22 at the motor 22, heat may be dissipated by using the second heat exchanger 24.

Optionally, a second pump 25 is further disposed in the second cooling fluid circulation loop 20. The second pump 25 is connected in series between the flow channel of the second heat exchanger 24 and the cold plate of the motor 22, and is configured to drive the cooling fluid in the second cooling fluid circulation loop 20 to flow.

In an embodiment, the vehicle may further include a second liquid cooling module 21. A cold plate (not shown in the figure) of the second liquid cooling module 21 is connected in series to the flow channel of the second heat exchanger 24, to connect the second liquid cooling module 21 and the second cooling fluid circulation loop 20. After the cooling fluid in the second cooling fluid circulation loop 20 absorbs heat generated by the second liquid cooling module 21 at the second liquid cooling module 21, heat may be dissipated by using the second heat exchanger 24.

Optionally, in the second cooling fluid circulation loop 20, a flow channel of the second liquid cooling module 21 may be connected in series to the cold plate of the motor 22, or may be connected in parallel to the cold plate of the motor 22.

When the flow channel of the second liquid cooling module 21 is connected in parallel to the cold plate of the motor 22, a three-way valve 23 is further disposed in the second cooling fluid circulation loop 20. One end of the cold plate of the motor 22 and one end of the cold plate of the second liquid cooling module 21 separately communicates with the flow channel of the second heat exchanger 24 through the three-way valve 23. Specifically, the three-way valve 23 includes a first end, a second end, and a third end. The first end communicates with the flow channel of the second heat exchanger 24, the second end communicates with the cold plate of the motor 22, and the third end communicates with the cold plate of the second liquid cooling module 21, so that the flow channel of the second heat exchanger 24 communicates with both the cold plate of the motor 22 and the cold plate of the second liquid cooling module 21 through the three-way valve 23.

The first liquid cooling module 11 and the second liquid cooling module 21 may be vehicle-mounted intelligent modules. The intelligent module may include but is not limited to a vehicle-mounted mobile data center (mobile data center, MDC), an advanced driver assistance system (advanced driver assistance system, ADAS), and the like.

In this embodiment of this application, the third cooling fluid circulation loop 30 includes a flow channel of a third heat exchanger 31, a compressor 32, and a second flow channel (not shown) of the first heat exchanger 40. Cooling fluid in the second flow channel of the first heat exchanger 40 is used to exchange heat with the cooling fluid in the first flow channel. After the cooling fluid in the third cooling fluid circulation loop 30 absorbs heat of the cooling fluid in the first flow channel of the first heat exchanger 40 at the second flow channel of the first heat exchanger 40, heat may be dissipated by using the third heat exchanger 31.

In this embodiment of this application, the vehicle further includes a fan 50. The second heat exchanger 24 may be disposed adjacent to the third heat exchanger 31. The fan 50 may be disposed at the second heat exchanger 24 and the third heat exchanger 31. The fan 50 is configured to accelerate air flow at the second heat exchanger 24 and the third heat exchanger 31.

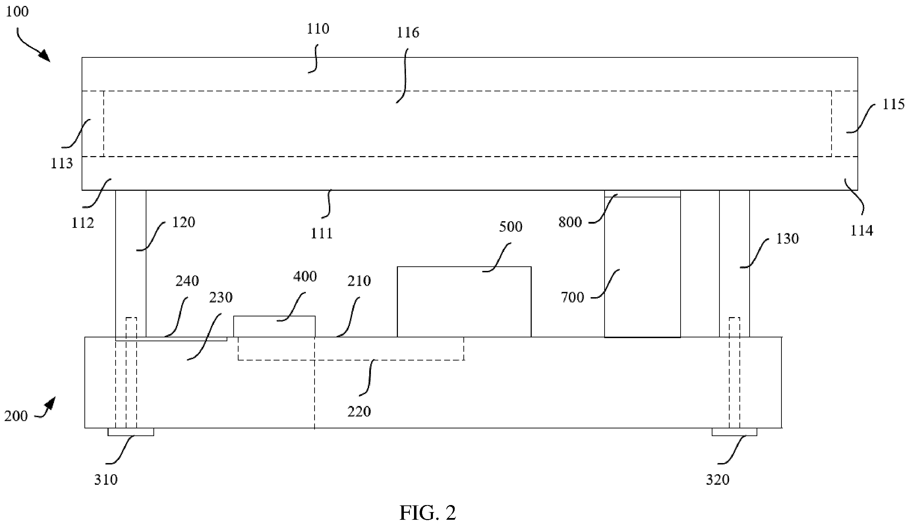

The cooling fluid circulation loops 10, 20, and 30 show different implementations of the cooling fluid circulation loops in the vehicle. During actual deployment, different quantities of cooling fluid circulation loops may be deployed in the vehicle, to dissipate heat for different liquid cooling modules. FIG. 2 is a diagram of a structure of a liquid cooling module according to an embodiment of this application.

As shown in FIG. 2, in this embodiment of this application, the liquid cooling module includes a cold plate 100 and a circuit board 200. The cold plate 100 includes a main body part 110, and the main body part 110 is fastened to the circuit board 200. The main body part 110 includes a first surface 111. The circuit board 200 includes a second surface 210. The first surface 111 is disposed opposite to the second surface 210. There is a spacing between the first surface 111 and the second surface 210. A component 700 may be disposed between the first surface 111 and the second surface 210. The component 700 between the first surface 111 and the second surface 210 may be mounted on the second surface 210. The component 700 may be electrically connected to a circuit of the circuit board 200. The component 700 may be connected to the first surface 111 through a first thermally conductive medium (for example, the first thermally conductive medium may be filled between a surface that is of the component 700 and that is away from the circuit board 200 and the first surface 111, to dissipate heat for the component 700 through the first thermally conductive medium).

The first thermally conductive medium may include a first thermal interface material 800 (thermal interface material, TIM). The first thermal interface material 800 may include but is not limited to one or more of a thermally conductive gel, a thermally conductive pad, and the like.

The liquid cooling module provided in this embodiment of this application may be the first liquid cooling module 11. In other words, the liquid cooling module provided in this embodiment of this application may be connected to the first cooling fluid circulation loop 10, and the liquid cooling module may be connected in series to the first flow channel of the first heat exchanger 40.

Alternatively, the liquid cooling module provided in this embodiment of this application may be the second liquid cooling module 21. In other words, the liquid cooling module provided in this embodiment of this application may be connected to the second cooling fluid circulation loop 20, and the liquid cooling module may be connected in series to the flow channel of the second heat exchanger 24.

In this embodiment of this application, the main body part 110 has an inlet end 112 and an outlet end 114. The main body part 110 has a flow channel 116 inside. The inlet end 112 is provided with a cooling fluid inlet 113 for cooling fluid to flow into the flow channel 116. The outlet end 114 is provided with a cooling fluid outlet 115 for the cooling fluid in the flow channel 116 to flow out. The main body part 110 is connected to a cooling fluid circulation loop through the cooling fluid inlet 113 and the cooling fluid outlet 115.

Optionally, when the liquid cooling module is the first liquid cooling module 11, the flow channel 116 in the main body part 110 is connected in series to the first flow channel of the first heat exchanger 40 through the cooling fluid inlet 113 and the cooling fluid outlet 115, to connect the flow channel 116 and the first cooling fluid circulation loop 10.

Optionally, when the liquid cooling module is the second liquid cooling module 21, the flow channel 116 in the main body part 110 is connected in series to the flow channel of the second heat exchanger 24 through the cooling fluid inlet 113 and the cooling fluid outlet 115, to connect the flow channel 116 and the second cooling fluid circulation loop 20.

To monitor a temperature of the cooling fluid in the cold plate, the liquid cooling module may further include a temperature sensor 400.

In an implementation, to enable the temperature sensor 400 to detect the temperature of the cooling fluid in the flow channel 116, a groove for accommodating the temperature sensor 400 may be formed on a surface of a side that is of the main body part 110 and that faces the circuit board 200. The temperature sensor 400 may be fastened in the groove through a thermally conductive adhesive. The temperature sensor 400 may monitor the temperature of the cooling fluid in the flow channel 116 by using the thermally conductive adhesive and a flow channel wall of the flow channel 116. Because the main body part 110 and the circuit board 200 are spaced from each other, the temperature sensor 400 disposed in the groove needs to be fastened to the circuit board 200 through a long pin. The long pin may be configured to: support the temperature sensor 400 and transmit data between the temperature sensor 400 and a line in the circuit board 200. Because the long pin has poor strength, the long pin is prone to be deformed or broken under the action of an external force. To ensure that the temperature sensor 400 is reliably connected to the circuit board 200 through the long pin, a protective sleeve needs to be sleeved on the long pin.

In the foregoing solution, the protective sleeve is sleeved on the long pin. This increases costs and also increases complexity of assembling the temperature sensor. Consequently, costs of assembling, on the circuit board, the temperature sensor configured to monitor the temperature of the cooling fluid in the flow channel 116 are high, and assembling is complex.

Based on the foregoing reasons, as shown in FIG. 2, in this embodiment of this application, the cold plate 100 further includes a first protruding part 120. The first protruding part 120 is disposed on the first surface 111. The temperature sensor 400 is disposed on the second surface 210. The temperature sensor 400 is disposed adjacent to the first protruding part 120. The temperature sensor 400 is connected to the first protruding part 120 through a thermally conductive medium.

That the temperature sensor 400 is disposed adjacent to the first protruding part 120 means that there is a specific spacing between the temperature sensor 400 and the first protruding part 120, and the temperature sensor 400 is connected to the first protruding part 120 through the thermally conductive medium instead of being directly connected to the first protruding part 120. The temperature sensor 400 may be as close as possible to the first protruding part 120. In other words, in a direction in which the first protruding part 120 faces the temperature sensor 40, a spacing between the component 700 disposed on the second surface 210 and the first protruding part 120 is greater than the spacing between the temperature sensor 400 and the first protruding part 120. For example, the temperature sensor 400 may be a thermistor.

In this way, the temperature sensor 400 may be configured to exchange heat with the first protruding part 120, and the temperature sensor 400 may monitor the temperature of the cooling fluid in the flow channel 116 by using the first protruding part 120, so that during assembling of the temperature sensor 400, no temperature sensor with long pins needs to be connected to the circuit board 200, and no protective sleeve needs to be disposed on the circuit board 200. Therefore, complexity of assembling the temperature sensor 400 is reduced, and reliability is improved.

In this embodiment of this application, the vehicle further includes a processor 500. The temperature sensor 400 is electrically connected to the processor 500, to transmit temperature-related data to the processor 500. The processor 500 is configured to determine a temperature of cooling fluid in the main body part 110 based on the temperature-related data. The processor 500 may be deployed in the liquid cooling module, for example, on the circuit board 200, or the processor 500 may be deployed on another module other than the liquid cooling module.

In an embodiment, the processor 500 is specifically configured to: determine a detected temperature at the temperature sensor 400 based on the temperature-related data, and determine the temperature of the cooling fluid in the main body part 110 based on the detected temperature and a temperature difference. The temperature difference is a pre-obtained difference between the temperature at the temperature sensor 400 and the temperature of the cooling fluid in the main body part 110.

In this way, the detected temperature at the temperature sensor 400 can be obtained, to monitor the temperature of the cooling fluid in the main body part 110. Further, when the component 700 in the liquid cooling module is overheated and powered off, it may be determined whether the temperature of the cooling fluid in the main body part 110 is excessively high, to determine whether the cooling fluid circulation loop connected to the liquid cooling module is faulty. This helps locate a faulty part that causes the component 700 to be overheated and powered off.

In an implementation, during determining of the temperature difference, differences between temperatures at the temperature sensor 400 and temperatures of the cooling fluid in the main body part 110 may be pre-obtained when the liquid cooling module is in various working conditions. Then, the temperature difference is determined based on a maximum value of the obtained differences between the temperatures at the temperature sensor 400 and the temperatures of the cooling fluid in the main body part 110 when the liquid cooling module is in various working conditions.

The liquid cooling module may have working conditions of different power duties (for example, 30% output, 50% output, 70% output, and 100% output) and working conditions in which the cooling fluid in the flow channel 116 has different flow rates (for example, 3 L/min, 5 L/min, 7 L/min, and 10 L/min). During determining of the temperature difference, a flow rate of the cooling fluid in the flow channel 116 may be fixed. Then, a power duty may be changed, to obtain, on the basis that the cooling fluid in the flow channel 116 has a specific flow rate, differences between temperatures at the temperature sensor 400 and temperatures of the cooling fluid in the main body part 110 when the liquid cooling module has various power duties. A power duty may be fixed, and a flow rate of the cooling fluid in the flow channel 116 may be changed, to obtain, based on a specific power duty, differences between temperatures at the temperature sensor 400 and temperatures of the cooling fluid in the main body part 110 when the cooling fluid in the flow channel 116 of the liquid cooling module has various flow rates.

For example, it is assumed that a maximum temperature allowed by the cooling fluid in the main body part 110 is 65°, and the determined temperature difference is 7°. When it is detected that the temperature at the temperature sensor 400 exceeds 72°, it indicates that the temperature of the cooling fluid in the main body part 110 is excessively high, and the cooling fluid circulation loop connected to the liquid cooling module may be faulty. When it is detected that the temperature at the temperature sensor 400 is less than 72°, and the component 700 of the liquid cooling module is overheated and powered off, it indicates that the temperature of the cooling fluid in the main body part 110 is not excessively high, and some parts in the liquid cooling module may be faulty.

In some embodiments of this application, the liquid cooling module includes the processor 500. The processor 500 is disposed on the circuit board 200.

In this way, a data transfer path between the processor 500 and the temperature sensor 400 is short. This facilitates data transfer between the temperature sensor 400 and the processor 500.

When the processor 500 is disposed in a direction in which the first protruding part 120 faces the temperature sensor 40, a spacing between the processor 500 and the first protruding part 120 is greater than the spacing between the temperature sensor 400 and the first protruding part 120.

In some embodiments of this application, the temperature sensor 400 is electrically connected to the processor 500 through a line 220 in the circuit board 200.

In this way, the temperature sensor 400 is conveniently connected to the processor 500 without a need to perform wiring outside the circuit board 200.

In some embodiments of this application, the temperature sensor 400 may alternatively be electrically connected to the processor 500 through an external cable.

In this embodiment of this application, the temperature sensor 400 may be a surface-mount sensor, and the temperature sensor 400 may be attached to the second surface 210.

In this way, stability of a connection between the temperature sensor 400 and the circuit board 200 is good. In addition, the temperature sensor 400 has small impact on wiring of the line 220 in the circuit board 200.

In this embodiment of this application, the first protruding part 120 is located at the inlet end 112.

In this way, the temperature of the cooling fluid flowing into the flow channel 116 is conveniently monitored, and whether the temperature of the cooling fluid entering the flow channel 116 is excessively high is conveniently determined, to determine whether the cooling fluid circulation loop connected to the flow channel 116 is faulty.

In some embodiments of this application, one end that is of the first protruding part 120 and that is away from the main body part 110 is in contact with the second surface 210. The circuit board 200 includes a thermally conductive part 230 located between the first protruding part 120 and the temperature sensor 400. The thermally conductive medium includes the thermally conductive part 230. The first protruding part 120 is connected to the temperature sensor 400 through the thermally conductive part 230.

In this way, the temperature sensor 400 can exchange heat with the first protruding part 120 by using the circuit board 200. Therefore, a structure is simple, and assembling is convenient. In addition, this facilitates detaching of the temperature sensor 400, to conveniently maintain or replace the temperature sensor 400.

In an embodiment in which the end that is of the first protruding part 120 and that is away from the main body part 110 is in contact with the second surface 210, the thermally conductive part 230 may further include a thermally conductive sheet 240, one end of the thermally conductive sheet 240 is close to the first protruding part 120, and the other end of the thermally conductive sheet 240 is close to the temperature sensor 400.

In this way, the thermally conductive sheet 240 is disposed, so that thermally conductive efficiency between the first protruding part 120 and the temperature sensor 400 can be improved. This helps reduce a temperature difference between the temperature sensor 400 and the first protruding part 120.

In an embodiment, the thermally conductive sheet 240 may be a copper foil of the circuit board 200.

In an embodiment in which the thermally conductive part 230 includes the thermally conductive sheet 240, the thermally conductive sheet 240 is located on a surface layer of a side that is of the thermally conductive part 230 and that faces the main body part 110.

In this way, the thermally conductive sheet 240 is located on a surface layer of a side that is of the circuit board 200 and on which the first protruding part 120 and the temperature sensor 400 are disposed. In a thickness direction of the circuit board 200, spacings between the thermally conductive sheet 240 and the first protruding part 120 and the temperature sensor 400 are small. This helps reduce the temperature difference between the temperature sensor 400 and the first protruding part 120.

In another embodiment, the thermally conductive sheet 240 may be a copper foil on a surface layer of the circuit board 200.

In some embodiments in which the thermally conductive part 230 includes the thermally conductive sheet 240, the temperature sensor 400 is disposed in non-contact with the thermally conductive sheet 240. In other words, the temperature sensor 400 and the thermally conductive sheet 240 may be spaced from each other, and the temperature sensor 400 and the thermally conductive sheet 240 are insulated from each other.

In this way, the temperature sensor 400 is conveniently electrically connected, through the line 220 in the circuit board 200, to the processor 500 disposed on the circuit board 200. In addition, the thermally conductive sheet 240 has small impact on arrangement of the line 220, a pad, and the like on a surface of the circuit board 200.

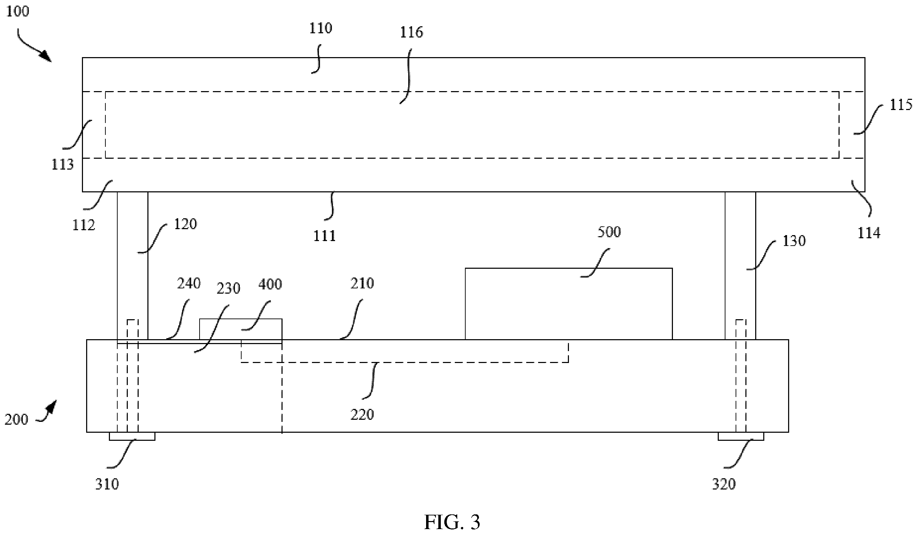

FIG. 3 is a diagram of a structure of another liquid cooling module according to an embodiment of this application.

As shown in FIG. 3, in some other embodiments in which the thermally conductive part 230 includes the thermally conductive sheet 240, at least a part of the temperature sensor 400 is disposed on a surface of the thermally conductive sheet 240.

In this way, the thermally conductive efficiency between the thermally conductive sheet 240 and the temperature sensor 400 is high. This helps reduce the temperature difference between the temperature sensor 400 and the first protruding part 120.

As shown in FIG. 3, in an embodiment, the temperature sensor 400 may be completely attached to the surface of the thermally conductive sheet 240. In this case, the temperature sensor 400 may be electrically connected to the processor 500 through the external cable, to transmit data between the temperature sensor 400 and the processor 500.

In this way, a thermally conductive area between the temperature sensor 400 and the thermally conductive sheet 240 is large, and the thermally conductive efficiency is high. This helps reduce the temperature difference between the temperature sensor 400 and the first protruding part 120.

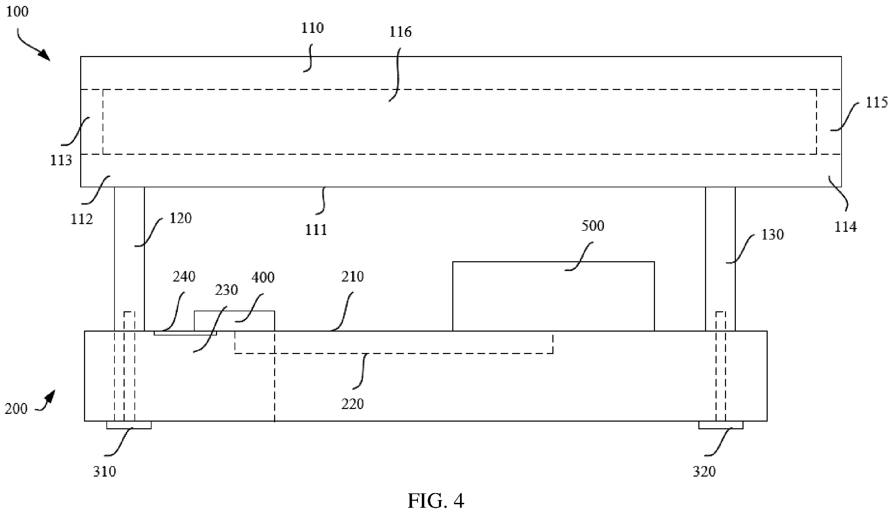

FIG. 4 is a diagram of a structure of still another liquid cooling module according to an embodiment of this application.

As shown in FIG. 4, in another embodiment, the temperature sensor 400 may alternatively be partially attached to the surface of the thermally conductive sheet 240. In this case, a part that is of the temperature sensor 400 and that is not attached to the surface of the thermally conductive sheet 240 may be electrically connected, through the line 220 in the circuit board 200, to the processor 500 disposed on the circuit board 200, to transmit data between the temperature sensor 400 and the processor 500.

In this way, on the basis that the thermally conductive efficiency between the thermally conductive sheet 240 and the temperature sensor 400 is high, the temperature sensor 400 can be conveniently electrically connected to the line 220, in the circuit board 200, for outputting data.

As shown in FIG. 3, in some embodiments in which the thermally conductive part 230 includes the thermally conductive sheet 240, at least a part of the end that is of the first protruding part 120 and that is away from the main body part 110 is in contact with the thermally conductive sheet 240.

In this way, a thermally conductive efficiency between the first protruding part 120 and the thermally conductive sheet 240 is high. This helps reduce the temperature difference between the temperature sensor 400 and the first protruding part 120.

When at least a part of the end that is of the first protruding part 120 and that is away from the main body part 110 is in contact with the thermally conductive sheet 240, an orthographic projection that is in the thickness direction of the circuit board 200 and that is of the end that is of the first protruding part 120 and that is away from the main body part 110 at least partially overlaps an orthographic projection that is of the thermally conductive sheet 240 and that is in the thickness direction of the circuit board 200.

In an embodiment, an end face of the end that is of the first protruding part 120 and that is away from the main body part 110 may be completely in contact with the thermally conductive sheet 240. In this case, the orthographic projection that is in the thickness direction of the circuit board 200 and that is of the end that is of the first protruding part 120 and that is away from the main body part 110 is located in the orthographic projection that is of the thermally conductive sheet 240 and that is in the thickness direction of the circuit board 200.

In this way, a thermally conductive area between the first protruding part 120 and the thermally conductive sheet 240 is large, and the thermally conductive efficiency is high. This helps reduce the temperature difference between the temperature sensor 400 and the first protruding part 120.

In another embodiment, an end face of the end that is of the first protruding part 120 and that is away from the main body part 110 may be partially in contact with the thermally conductive sheet 240. In this case, the orthographic projection that is in the thickness direction of the circuit board 200 and that is of the end that is of the first protruding part 120 and that is away from the main body part 110 is partially located in the orthographic projection that is of the thermally conductive sheet 240 and that is in the thickness direction of the circuit board 200 and is partially located outside the orthographic projection that is of the thermally conductive sheet 240 and that is in the thickness direction of the circuit board 200.

In this way, on the basis that the thermally conductive efficiency between the first protruding part 120 and the temperature sensor 400 is high, the thermally conductive sheet 240 has small impact on arrangement of the line 220 on the surface of the circuit board 200.

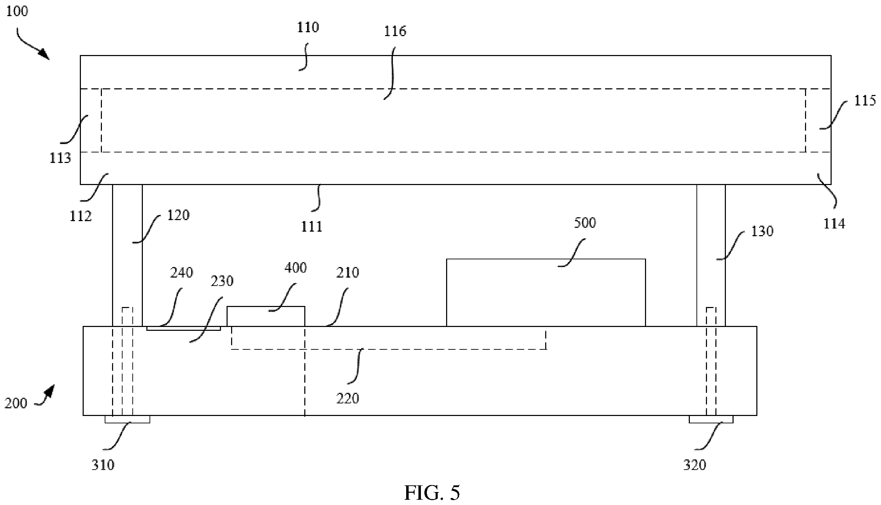

FIG. 5 is a diagram of a structure of still another liquid cooling module according to an embodiment of this application.

As shown in FIG. 5, in some other embodiments in which the thermally conductive part 230 includes the thermally conductive sheet 240, the end that is of the first protruding part 120 and that is away from the main body part 110 is disposed in non-contact with the thermally conductive sheet 240. In other words, the end that is of the first protruding part 120 and that is away from the main body part 110 and the thermally conductive sheet 240 may be spaced from each other.

In this way, the thermally conductive sheet 240 has small impact on arrangement of the line 220 on the surface of the circuit board 200.

In an embodiment in which the end that is of the first protruding part 120 and that is away from the main body part 110 is in contact with the second surface 210, the end that is of the first protruding part 120 and that is away from the circuit board 200 is fastened to the main body part 110, so that the main body part 110 is fastened to the circuit board 200 through the first protruding part 120.

In this way, the first protruding part 120 may be configured to enable the main body part 110 to be fastened to the circuit board 200, and may also be configured to exchange heat with the temperature sensor 400, so that the temperature sensor 400 can monitor the temperature of the cooling fluid in the flow channel 116 by using the first protruding part 120. In other words, the temperature sensor 400 can monitor the temperature of the cooling fluid in the flow channel 116 by using the first protruding part 120 that is configured to enable the main body part 110 to be fastened to the circuit board 200, so that a structure between the main body part 110 and the circuit board 200 can be simple, and assembling of the cold plate 100, the circuit board 200, and the temperature sensor 400 can be easy.

The end that is of the first protruding part 120 and that is away from the circuit board 200 may be fastened to the main body part 110 in a manner such as clamping, welding, fastener connection, or thermally conductive adhesive bonding.

In an embodiment in which the main body part 110 is fastened to the circuit board 200 through the first protruding part 120, a first threaded hole (not shown) is provided at the end that is of the first protruding part 120 and that is away from the main body part 110, the circuit board 200 is provided with a first mounting hole (not shown) opposite to the first threaded hole, the first mounting hole is a through hole, a first screw 310 passes through the first mounting hole, and the first screw 310 is in threaded connection with a hole wall of the first threaded hole, so that the circuit board 200 is fastened to the first protruding part 120.

In this way, the first protruding part 120 is stably connected to the circuit board 200, so that the first protruding part 120 stably exchanges heat with the temperature sensor 400 through the thermally conductive part 230. In addition, the first protruding part 120 is conveniently detached from the circuit board 200, to conveniently maintain or replace the circuit board 200 and the cold plate 100.

As shown in FIG. 5, in an embodiment in which the main body part 110 is fastened to the circuit board 200 through the first protruding part 120, the cold plate 100 further includes a second protruding part 130. The second protruding part 130 is disposed on the first surface 111. One end that is of the second protruding part 130 and that is away from the main body part 110 is fastened to the circuit board 200. The main body part 110 may be fastened to the circuit board 200 through the first protruding part 120 and the second protruding part 130.

In this way, the main body part 110 is stably fastened to the circuit board 200.

It may be understood that the end that is of the second protruding part 130 and that is away from the main body part 110 may be fastened to the circuit board 200 in a manner such as clamping, welding, fastener connection, or thermally conductive adhesive bonding.

The second protruding part 130 and the first protruding part 120 are spaced from each other. For example, the second protruding part 130 may be disposed at the outlet end 114 of the main body part 110.

In an embodiment in which the main body part 110 is fastened to the circuit board 200 through the first protruding part 120 and the second protruding part 130, a second threaded hole (not shown) is provided at the end that is of the second protruding part 130 and that is away from the main body part 110, the circuit board 200 is provided with a second mounting hole (not shown) opposite to the second threaded hole, the second mounting hole is a through hole, a second screw 320 passes through the second mounting hole, and the second screw 320 is in threaded connection with a hole wall of the second threaded hole, so that the circuit board 200 is fastened to the second protruding part 130.

In this way, the second protruding part 130 is stably connected to the circuit board 200, so that the second protruding part 130 stably exchanges heat with the temperature sensor 400 through the thermally conductive part 230. In addition, the second protruding part 130 is conveniently detached from the circuit board 200, to conveniently maintain or replace the circuit board 200 and the cold plate 100.

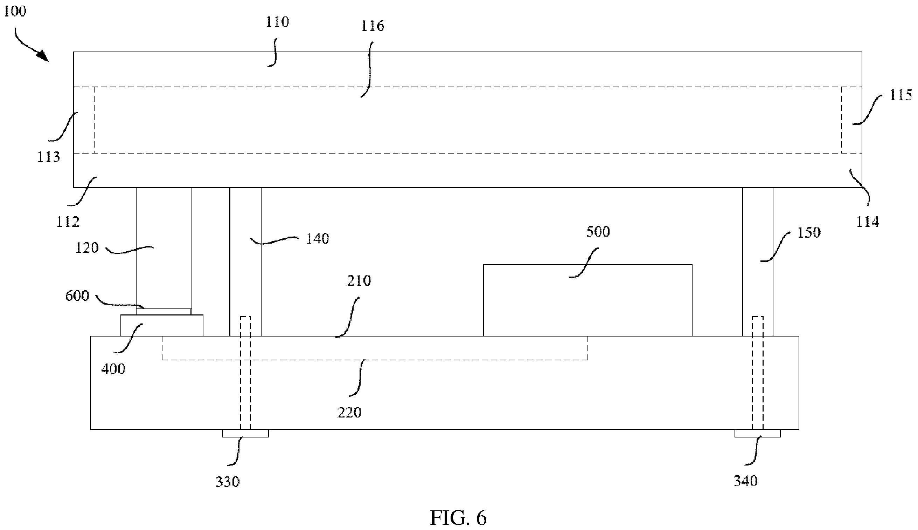

FIG. 6 is a diagram of a structure of still another liquid cooling module according to an embodiment of this application.

As shown in FIG. 6, in some embodiments of this application, the thermally conductive medium includes a second thermal interface material 600. The first protruding part 120 is disposed opposite to the temperature sensor 400, and an end face of one end that is of the first protruding part 120 and that is away from the main body part 110 is connected to the temperature sensor 400 through the second thermal interface material 600.

In this way, the temperature sensor 400 can exchange heat with the first protruding part 120 through the second thermal interface material 600 between the end that is of the first protruding part 120 and that is away from the main body part 110 and the temperature sensor 400, and thermally conductive efficiency between the first protruding part 120 and the temperature sensor 400 is high. In addition, the second thermal interface material 600 may also function as a buffer. When displacement between the first main body part 110 and the temperature sensor 400 does not exceed a preset value, the first main body part 110 can stably exchange heat with the temperature sensor 400.

The second thermal interface material 600 may include but is not limited to one or more of a thermally conductive gel, a thermally conductive pad, and the like.

In an embodiment in which the end face of the end that is of the first protruding part 120 and that is away from the main body part 110 is connected to the temperature sensor 400 through the second thermal interface material 600, the cold plate 100 further includes a third protruding part 140 and a fourth protruding part 150. Both the third protruding part 140 and the fourth protruding part 150 are disposed on the first surface 111. The third protruding part 140 and the fourth protruding part 150 are spaced from each other. One end that is of the third protruding part 140 and that is away from the main body part 110 is fastened to the circuit board 200. One end that is of the fourth protruding part 150 and that is away from the main body part 110 is fastened to the circuit board 200. The main body part 110 may be fastened to the circuit board 200 through the third protruding part 140 and the fourth protruding part 150.

The end that is of the third protruding part 140 and that is away from the main body part 110 may be fastened to the circuit board 200 in a manner such as clamping, welding, fastener connection, or thermally conductive adhesive bonding.

The end that is of the fourth protruding part 150 and that is away from the main body part 110 may be fastened to the circuit board 200 in a manner such as clamping, welding, fastener connection, or thermally conductive adhesive bonding.

In an embodiment in which the main body part 110 is fastened to the circuit board 200 through the third protruding part 140 and the fourth protruding part 150, a third threaded hole (not shown) is provided at the end that is of the third protruding part 140 and that is away from the main body part 110, the circuit board 200 is provided with a third mounting hole (not shown) opposite to the third threaded hole, the third mounting hole is a through hole, a third screw 330 passes through the third mounting hole, and the third screw 330 is in threaded connection with a hole wall of the third threaded hole, so that the circuit board 200 is fastened to the third protruding part 140. A fourth threaded hole (not shown) is provided at the end that is of the fourth protruding part 150 and that is away from the main body part 110, the circuit board 200 is provided with a fourth mounting hole (not shown) opposite to the fourth threaded hole, the fourth mounting hole is a through hole, a fourth screw 340 passes through the fourth mounting hole, and the fourth screw 340 is in threaded connection with a hole wall of the fourth threaded hole, so that the circuit board 200 is fastened to the fourth protruding part 150.

In this embodiment of this application, the main body part 110 and the first protruding part 120 are of an integrated structure.

In this way, the thermally conductive efficiency between the main body part 110 and the first protruding part 120 is high. This helps reduce the temperature difference between the temperature sensor 400 and the cooling fluid in the flow channel 116. In addition, the main body part 110 is firmly fastened to the first protruding part 120, and heat transfer between the main body part 110 and the first protruding part 120 is stable.

In an embodiment in which the cold plate 100 includes the second protruding part 130, the main body part 110 and the second protruding part 130 may be of an integrated structure, or the second protruding part 130 may be fastened to the main body part 110 in a manner such as welding, bonding, clamping, or fastener connection.

In an embodiment in which the cold plate 100 includes the third protruding part 140 and the fourth protruding part 150, the third protruding part 140 and the main body part 110 may be of an integrated structure, or the third protruding part 140 may be fastened to the main body part 110 in a manner such as welding, bonding, clamping, or fastener connection. The fourth protruding part 150 and the main body part 110 may be of an integrated structure, or the fourth protruding part 150 may be fastened to the main body part 110 in a manner such as welding, bonding, clamping, or fastener connection.

In descriptions of embodiments of this application, it should be noted that, unless otherwise clearly specified and limited, the terms "mount", "connect to", and "connection" should be understood in a broad sense. For example, the connection may be a fixed connection, may be an indirect connection through an intermediate medium, or may be an internal connection between two elements or an interaction relationship between two elements. Persons of ordinary skill in the art may understand specific meanings of the terms in embodiments of this application based on a specific case.

In the specification, claims, and accompanying drawings of embodiments of this application, the terms "first", "second", "third", "fourth", and the like (if exist) are intended to distinguish between similar objects but do not necessarily indicate a specific order or sequence.

Finally, it should be noted that the foregoing embodiments are merely intended for describing the technical solutions of embodiments of this application other than limiting embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A liquid cooling module, comprising a cold plate, a circuit board, and a temperature sensor, wherein
the cold plate comprises a main body part and a protruding part, and the main body part is fastened to the circuit board;
the main body part comprises a first surface, the circuit board comprises a second surface, the first surface is disposed opposite to the second surface, and the protruding part is disposed on the first surface; and
the temperature sensor is disposed on the second surface, the temperature sensor is disposed adjacent to the protruding part, and the temperature sensor is connected to the protruding part through a thermally conductive medium.

2. The liquid cooling module according to claim 1, wherein the main body part has an inlet end, and the protruding part is located at the inlet end; and
the main body part has a flow channel inside, and the inlet end of the main body part is provided with a cooling fluid inlet for cooling fluid to flow into the flow channel.

3. The liquid cooling module according to claim 1 or 2, wherein one end that is of the protruding part and that is away from the main body part is in contact with the second surface; and
the circuit board comprises a thermally conductive part located between the protruding part and the temperature sensor, the thermally conductive medium comprises the thermally conductive part, and the protruding part is connected to the temperature sensor through the thermally conductive part.

4. The liquid cooling module according to claim 3, wherein the thermally conductive part comprises a thermally conductive sheet, one end of the thermally conductive sheet is close to the protruding part, and the other end of the thermally conductive sheet is close to the temperature sensor.

5. The liquid cooling module according to claim 4, wherein the temperature sensor is disposed in non-contact with the thermally conductive sheet, and the temperature sensor and the thermally conductive sheet are insulated from each other.

6. The liquid cooling module according to claim 4, wherein at least a part of the temperature sensor is disposed on a surface of the thermally conductive sheet.

7. The liquid cooling module according to any one of claims 4 to 6, wherein at least a part of the end that is of the protruding part and that is away from the main body part is in contact with the thermally conductive sheet.

8. The liquid cooling module according to any one of claims 4 to 6, wherein the end that is of the protruding part and that is away from the main body part is disposed in non-contact with the thermally conductive sheet.

9. The liquid cooling module according to any one of claims 1 to 8, wherein the end that is of the protruding part and that is away from the main body part is fastened to the circuit board, so that the main body part is fastened to the circuit board through the protruding part.

10. The liquid cooling module according to claim 9, wherein a threaded hole is provided at the end that is of the protruding part and that is away from the main body part, the circuit board is provided with a mounting hole opposite to the threaded hole, the mounting hole is a through hole, a screw passes through the mounting hole, and the screw is in threaded connection with a hole wall of the threaded hole, so that the circuit board is fastened to the protruding part.

11. The liquid cooling module according to claim 1 or 2, wherein the thermally conductive medium comprises a thermal interface material; and
the protruding part is disposed opposite to the temperature sensor, and an end face of one end that is of the protruding part and that is away from the main body part is connected to the temperature sensor through the thermal interface material.

12. The liquid cooling module according to any one of claims 1 to 11, wherein the main body part and the protruding part are of an integrated structure.

13. The liquid cooling module according to any one of claims 1 to 12, further comprising a processor, wherein the processor is disposed on the circuit board;
the temperature sensor is electrically connected to the processor through a line in the circuit board, to transmit temperature-related data to the processor; and
the processor is configured to determine a temperature of cooling fluid in the main body part based on the temperature-related data.

14. The liquid cooling module according to claim 13, wherein the processor is specifically configured to: determine a detected temperature at the temperature sensor based on the temperature-related data, and determine the temperature of the cooling fluid in the main body part based on the detected temperature and a temperature difference, wherein the temperature difference is a pre-obtained difference between the temperature at the temperature sensor and the temperature of the cooling fluid in the main body part.

15. The liquid cooling module according to any one of claims 1 to 14, wherein the temperature sensor is a surface-mount sensor, and the temperature sensor is attached to the second surface.

16. A vehicle, comprising a heat exchanger and the liquid cooling module according to any one of claims 1 to 15, wherein
a main body part of a cold plate of the liquid cooling module is connected in series to the heat exchanger, so that a cooling fluid circulation loop is formed between the heat exchanger and the main body part.
